# FASCICULE DE BREVET EUROPEEN

(11) **EP 0 785 703 B1**
(45) Date de publication et mention de la délivrance du brevet: **16.12.1998**
(21) Numéro de dépôt: 97460006.6
(22) Date de dépôt: 16.01.1997
(51) Int. Cl.: H05B 41/29

(54) **Dispositif de commande pour lampe fluorescente à basse pression**
Regelvorrichtung einer Niederdruckleuchtstofflampe
Control device for a low pressure fluorescent lamp

(30) Priorité: 19.01.1996 FR 9600823
(43) Date de publication de la demande: 23.07.1997
(73) Titulaire: SGS-THOMSON MICROELECTRONICS S.A., 94250 Gentilly (FR)
(72) Inventeur: Bildgen, Marco, 56100 Lorient (FR)
(74) Mandataire: Schmit, Christian Norbert Marie

(56) Documents cités:
- EP-A- 0 171 108
- EP-A- 0 390 285
- EP-A- 0 399 613
- FR-A- 2 519 207
- FR-A- 2 687 513
- US-A- 5 164 637

## Description

L'invention concerne un dispositif de commande pour une lampe fluorescente basse pression.

Le comportement électrique des lampes fluorescentes contenant des gaz à basse pression, est similaire à celui d'une diode zener (avalanche), avec une résistance dans le gaz qui devient très faible et négative après le claquage. Des ions animés de vitesses importantes conduisent les atomes du gaz dans des états excités dans lesquels ils émettent des raies lumineuses.

Pour commander ces lampes, on utilise un dispositif de commande à source de courant et un circuit oscillant dans lequel est placé la lampe. Ce circuit oscillant comprend typiquement une inductance et un premier condensateur en série avec la lampe ainsi qu'un second condensateur en parallèle avec la lampe. Ce système permet de faire passer des décharges de courant entre les deux électrodes de la lampe dans les deux sens.

Classiquement, le dispositif de commande à source de courant comprend deux commutateurs électroniques à transistors de puissance alimentés par une haute tension continue et un transformateur de courant. Le transformateur de courant est de préférence un transformateur à saturation, qui limite le courant dans la lampe par saturation de son noyau et entraîne la commutation des commutateurs.

Les commutateurs électroniques utilisent généralement des transistors de puissance en technologie bipolaire pour la commutation et des diodes en parallèle polarisées en inverse pour laisser passer le courant au moment des alternances, et différents éléments de protection.

Ces dispositifs à transformateur sont très encombrants et coûteux, car ils nécessitent beaucoup de composants et ne permettent que peu d'intégration.

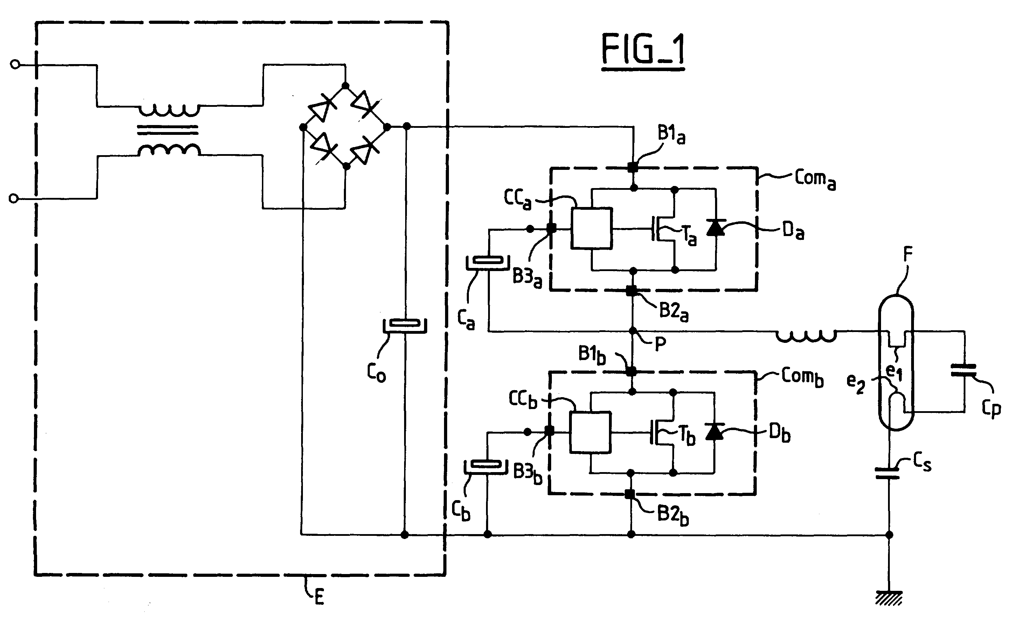

Pour remédier à ces inconvénients de coût et de faible intégration, des dispositifs de commande sans transformateur ont été développés. Ces dispositifs illustrés à la figure 1 comprennent deux circuits de commutation, Comₐ et Com_{b}, montés en série entre une haute tension d'alimentation et la masse. Chaque circuit de commutation comprend un transistor de puissance Tₐ, T_{b} avec une diode Dₐ, D_{b} montée en parallèle et en inverse formant le commutateur, et un circuit de commande CCₐ, CC_{b} de la grille du transistor. La diode est en général une diode parasite du transistor.

Les circuits de commande CCₐ et CC_{b} comprennent un circuit de détection de la tension aux bornes de la diode Dₐ, D_{b} pour commander l'état passant du transistor Tₐ, T_{b} lorsque cette tension est nulle et un circuit de mesure du courant passant dans le transistor Tₐ, T_{b} pour commander l'état bloqué du transistor lorsque l'intégrale de ce courant est supérieure à une valeur de référence de courant.

Le principe de fonctionnement du dispositif de commande est le suivant: on considère qu'au démarrage, le circuit de commutation Comₐ est fermé c'est-à-dire que le transistor Tₐ est passant et que le circuit de commutation Com_{b} est ouvert.

Le circuit de commutation Comₐ laisse donc passer le courant circulant dans la lampe F et mesure ce courant. Lorsqu'il détecte que suffisamment de courant est passé dans le transistor Tₐ, il passe dans un état ouvert. La tension aux bornes de l'inductance s'inverse et le courant de la lampe qui doit continuer à passer quelque part, passe alors dans la diode D_{b} montée en inverse du second circuit de commutation Com_{b}. Le passage du courant dans la diode D_{b} fait chuter la tension à ses bornes. Cette chute de tension est ensuite détectée par le circuit de commande CC_{b} et le transistor T_{b} devient passant. Dans le même temps, l'inductance du circuit oscillant se démagnétise. Quand elle est totalement démagnétisée, le condensateur Cs se décharge dans la lampe F et le courant passant dans la lampe circule dans l'autre sens.

Le dispositif de commande ainsi constitué est composé de deux circuits de commutation qui fonctionnent de manière indépendante. En effet, chaque circuit détecte une chute de tension à ses bornes pour se mettre à l'état fermé puis détectant que suffisamment de courant est passé entre ses bornes, il se met à l'état ouvert.

A la fréquence de résonnance f₀ du système circuit oscillant-lampe, on remarque que les circuits de commutation sont ouverts successivement pendant une demi-période. Dans ce type de dispositif, il n'est donc pas nécessaire que les deux circuits de commutation fonctionnent indépendamment.

Aussi, l'invention propose un dispositif de commande comportant un premier circuit de commutation intelligent tel que décrit précédemment et un second circuit de commutation flottant fonctionnant de manière dépendante vis à vis du premier.

L'invention a pour but de proposer un dispositif de commande qui soit moins onéreux et qui permette une meilleure intégration.

Ainsi, l'invention a pour objet un dispositif de commande d'une lampe fluorescente à basse pression comprenant un premier et un second circuit de commutation placés en série entre une haute tension et la masse, le premier circuit de commutation comportant un premier transistor de puissance, le second circuit de commutation comportant un second transistor de puissance, une inductance étant montée en série avec la lampe fluorescente à basse pression et avec un condensateur entre le point milieu des deux circuits de commutation et la masse,
caractérisé en ce que le premier circuit de commutation comporte:
- un circuit de mesure de la durée de conduction du second transistor de puissance, pour mesurer une première durée, et
- un circuit de mise en conduction pour rendre passant le premier transistor de puissance pendant une seconde durée consécutive et égale à la première durée.

D'autres avantages et caractéristiques de l'invention sont présentés dans la description jointe, faite à titre indicatif et non limitatif de l'invention et en référence aux dessins annexés, dans lesquels :
- la figure 1 est un schéma d'ensemble d'un dispositif de commande d'une lampe fluorescente à basse pression selon l'invention;
- la figure 2 est un schéma détaillé d'un circuit de commutation flottant selon l'invention, et
- la figure 3 est un diagramme temporel de la tension aux bornes d'un condensateur du circuit de commutation flottant selon l'invention.

La figure 1 représente un dispositif de commande d'une lampe fluorescente à basse pression.

Le dispositif de commande comprend deux circuits de commutation différents Comₐ et Com_{b} placés en série entre une haute tension et la masse. Dans l'exemple, la haute tension est fournie par un étage E d'alimentation à redresseur et capacité de filtrage C₀ pour maintenir une tension d'alimentation continue de l'ordre de 300 volts aux bornes du dispositif de commande.

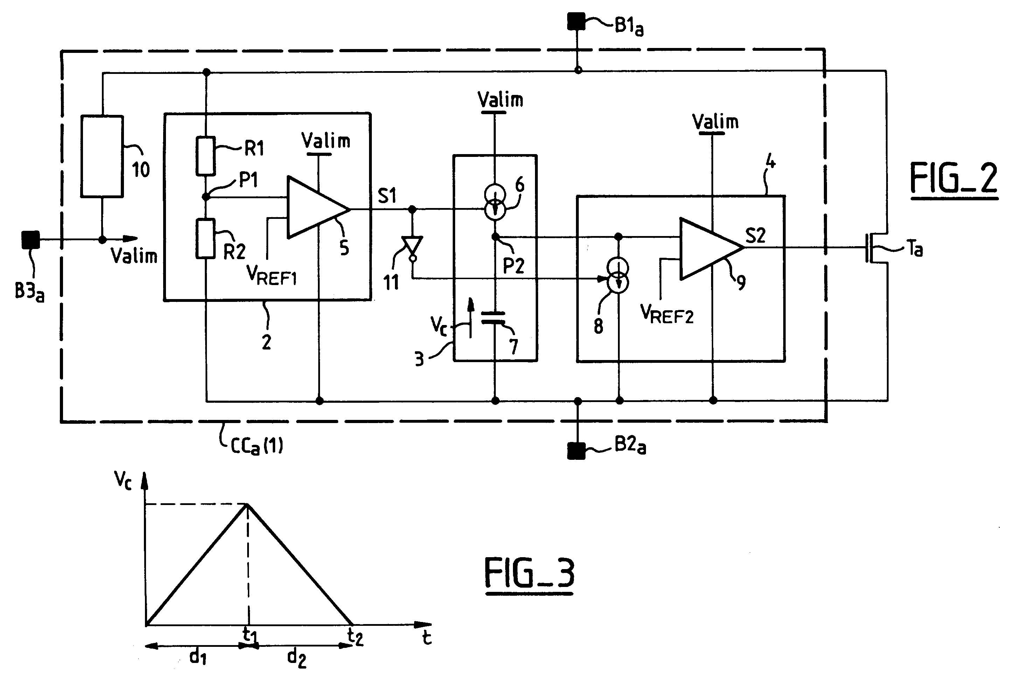

Dans l'exemple, le circuit Com_{b} est un circuit de commutation intelligent fonctionnant de manière indépendante tel que décrit dans le préambule de la demande. Le circuit Comₐ est détaillé à la figure 2.

Les circuits Comₐ et Com_{b} possèdent trois bornes externes notées respectivement B1ₐ, B2ₐ, B3ₐ et B1_{b}, B2_{b}, B3_{b}. Les bornes B1ₐ et B2ₐ (respectivement B1_{b} et B2_{b}) sont les bornes de connexion du circuit. La borne B3ₐ (respectivement B3_{b}) est une borne de découplage pour l'alimentation de circuits internes au circuit de commutation.

Les bornes B3ₐ et B3_{b} sont chacune reliées à un condensateur de découplage Cₐ et C_{b} connecté respectivement aux bornes B2ₐ et B2_{b} des circuits. Le rôle de ces condensateurs est de maintenir une tension d'alimentation interne dans les circuits Comₐ et Com_{b} quelle que soit la tension entre leurs bornes de connexion B1ₐ et B2ₐ, B1_{b} et B2_{b}.

Les circuits de commutation Comₐ, Com_{b} comprennent principalement un transistor de puissance Tₐ, T_{b} et un circuit de commande de grille CCₐ, CC_{b} entre les deux bornes de connexion B1ₐ et B2ₐ, B1_{b} et B2_{b}. Les circuits de commande CCₐ et CC_{b} commandent respectivement les grilles des transistors Tₐ et T_{b}. Une diode Dₐ, D_{b} est placée en parallèle et en inverse sur le transistor Tₐ, T_{b}.

Dans l'exemple préféré, les transistors Tₐ et T_{b} sont des transistors de puissance de type MOSFET. Pour les rendre passant, il est nécessaire d'appliquer sur leur grille une tension de l'ordre de quinze volts et pour les bloquer, une tension de l'ordre de zéro volt.

Le point milieu P entre les deux circuits de commutation Comₐ et Com_{b} est connecté à une borne d'une inductance L connectée sur l'autre borne à une première électrode el d'une lampe fluorescente à basse pression F. La deuxième électrode e2 de la lampe est connectée à un condensateur Cs dont l'autre borne est reliée à la masse. L'inductance L, la lampe F et le condensateur Cs sont donc montés en série et forment un circuit oscillant.

Par ailleurs, un condensateur de démarrage Cp est monté en parallèle sur la lampe F. Une surtension aux bornes de ce condensateur provoque le claquage du gaz de la lampe pendant le démarrage de la lampe.

Le principe général du fonctionnement du dispositif de commande de la lampe selon l'invention est le suivant. Le courant circulant dans la lampe passe tantôt dans un sens, tantôt dans l'autre. Pendant une première durée, on considère que le courant passe dans le transistor de puissance T_{b}. Le transistor Ta est bloqué. La tension entre les deux bornes de connexion du circuit Com_{b} est alors nulle et toute la haute tension se retrouve entre les bornes de connexion du circuit de commutation Comₐ. Le circuit de commutation Com_{b} mesure le courant traversant le transistor T_{b} pour le bloquer lorsque l'intégrale de ce courant dépasse une valeur de courant de référence.

Dans le même temps, le circuit Comₐ mesure la durée pendant laquelle le transistor T_{b} est passant. Quand suffisamment de courant est passé à travers le transistor T_{b}, le circuit Com_{b} commande le blocage du transistor T_{b} et passe dans un état ouvert. Le circuit Comₐ détecte alors le changement d'état du circuit Com_{b} et passe dans un état fermé.

Le courant circulant dans la lampe passe alors par le circuit Comₐ. La diode Dₐ montée en inverse laisse passer le courant au moment de l'alternance. Suite au changement d'état du transistor de puissance T_{b}, le transistor de puissance Tₐ devient passant. Le circuit de commutation Comₐ se maintient à l'état fermé pendant une durée équivalente à la durée mesurée préalablement. Lorsque le transistor Tₐ se bloque à nouveau, le courant de la lampe passe dans la diode D_{b}. Le circuit Com_{b} détecte alors une tension très faible aux bornes de la diode, et le transistor T_{b} redevient passant.

Le dispositif constitué d'un circuit intelligent Com_{b} et d'un circuit dépendant Comₐ trouve un intérêt particulier dans le fait que les deux circuits de commande ne peuvent simultanément être dans le même état, auquel cas le système circuit oscillant-lampe ne démarrerait pas.

La figure 2 est un schéma détaillé d'un circuit de commutation Comₐ possible comprenant le transistor Tₐ et son circuit de commande CCₐ associé. La diode Dₐ est une diode parasite du transistor Tₐ. Il comporte tout d'abord trois bornes extérieures: deux bornes de connexion B1ₐ et B2ₐ et une borne de découplage B3ₐ.

Le transistor de puissance Tₐ est connecté entre les bornes B1ₐ et B2ₐ du circuit. Le circuit de commande CCa comporte un circuit de détection 2 de la conduction du transistor de puissance T_{b}, un circuit de mesure 3 de la durée de la conduction du transistor de puissance T_{b}, et un circuit de mise en conduction 4 pour rendre passant le transistor de puissance Tₐ pendant une durée égale à la durée mesurée par le circuit de mesure 3 lorsque le transistor de puissance T_{b} est bloqué.

Tout d'abord, le circuit de commutation Comₐ détecte l'état du transistor de puissance T_{b}. Le circuit de détection 2 comprend un diviseur résistif constitué dans l'exemple de deux éléments résistifs R1 et R2 placés entre les bornes de connexion B1ₐ et B2ₐ. Ce diviseur a notamment pour objet de réduire l'excursion en tension entre les deux bornes de connexion, car elle peut atteindre 400 volts, pour la ramener à un niveau de tension plus acceptable par le comparateur de tension à suivre.

Le point milieu P1 entre les deux éléments résistifs est connecté à une première entrée négative d'un comparateur de tension 5, qui reçoit sur une seconde entrée positive une tension de référence V_{ref1}. Dans l'exemple, on veut que le comparateur modifie son niveau de sortie à chaque changement d'état du transistor de puissance T_{b}. Dans cet exemple, la valeur de la tension de référence V_{ref1} est choisie de façon à être supérieure à la tension au point P1 lorsque le transistor de puissance T_{b} est passant et inférieure sinon. Le comparateur de tension est classiquement une paire différentielle.

Le comparateur de tension 5 délivre en sortie un signal de détection s1 indiquant l'état du circuit de commutation Com_{b}. Ce signal de détection est à un niveau haut lorsque le transistor T_{b} est passant et à un niveau bas dans le cas contraire.

Pendant le niveau haut du signal de détection s1, le circuit de commutation Comₐ mesure la durée de conduction du transistor de puissance T_{b}. Le circuit de mesure 3 de la durée comprend une source de courant 6 en série avec un condensateur 7 placés entre une tension d'alimentation Vₐₗᵢₘ et la borne de connexion B2ₐ. La source de courant 6 est commandée par le signal de détection s1 issu du comparateur 5. La source de courant est donc activée lorsque le transistor T_{b} est passant. Pendant cette demi-période, le condensateur 7 se charge jusqu'à ce que le circuit de commutation Com_{b} passe dans un état ouvert. La charge du condensateur 7 au moment du blocage du transistor T_{b} constitue une mesure de la durée de conduction de ce transistor.

Le circuit de mise en conduction 4 comporte une source de courant 8 connecté entre le point milieu P2 de la source de courant 6 et du condensateur 7 et la borne connexion B2ₐ. La source de courant 8 permet de décharger le condensateur 7 lorsque le transistor T_{b} est bloqué. Par ailleurs, elle est commandée par le signal de détection inversé /s1 issu de la porte inverseuse 11. Le temps de décharge du condensateur représente une seconde durée pendant laquelle le transistor Tₐ est passant. Selon une réalisation avantageuse, les sources de courant 6 et 8 sont identiques afin que les temps de charge et de décharge du condensateur 7 soient égaux. Ces sources de courant peuvent être réalisées à partir de structure de type miroir de courant.

Par ailleurs, le point milieu P2 est connecté à l'entrée positive d'un comparateur de tension 9, qui reçoit sur son entrée négative une tension de référence V_{ref2}. Ce comparateur délivre un signal de mise en conduction s2.

Dans l'exemple, on choisit la valeur de la tension de référence V_{ref2} de telle sorte que la signal s2 soit à un niveau haut lorsque le transistor T_{b} est bloqué et lorsque, le transistor T_{b} étant passant, le condensateur 7 n'est pas entièrement déchargé. Le signal de mise en conduction s2 issu du comparateur de tension 9 permet de commander la grille du transistor de puissance Tₐ.

Enfin, un circuit de charge 10 est prévu pour charger le condensateur de découplage Cₐ afin que la tension d'alimentation Vₐₗᵢₘ présente sur la borne de découplage B3ₐ soit de l'ordre de quinze volts. La tension d'alimentation Vₐₗᵢₘ est utilisée pour alimenter les différents circuits (comparateurs de tension, sources de courant) du circuit de commutation Comₐ.

Ce circuit de charge 10 peut être constitué d'une source de courant montée en série avec une diode et connecté entre la borne de connexion B1ₐ et le condensateur de découplage Cₐ. Le condensateur de découplage Cₐ se charge avec le courant issu de la source de courant lorsque la tension entre les bornes de connexion B1ₐ et B2ₐ est élevée. Le condensateur de découplage maintient la tension d'alimentation Vₐₗᵢₘ lorsque le transistor de puissance Tₐ est passant.

Par ce montage, la différence de tension entre la borne de découplage B3ₐ et la borne de connexion B2ₐ est conservée quel que soit l'état du transistor de puissance Tₐ. En conséquence, les comparateurs de tension 5 et 9, les sources de courant 6 et 8 et la porte inverseuse 12 sont alimentés entre les bornes B3ₐ et B2ₐ.

Le fonctionnement global du circuit de commutation Comₐ est le suivant: lorsque le transistor T_{b} est passant, la tension au point P1 est inférieure à la tension de référence V_{ref1}. Le signal s1 est alors à un niveau haut. La source de courant commandée par ce signal s1 charge le condensateur 7. Pendant la charge du condensateur 7, la tension au point P2 étant inférieure à la tension de référence V_{ref2}, le signal s2 est à un niveau bas et le transistor Tₐ est bloqué.

Dès que le transistor T_{b} se bloque, l'augmentation de la tension au point P1 modifie l'état du signal de détection s1. Le signal s1 passe à un niveau bas et la source de courant 6 est coupée. A l'inverse, la source de courant 8 est activée et permet la décharge du condensateur 7. Tant que le condensateur n'est pas entièrement déchargé, la tension au point P2 est supérieure à la tension de référence V_{ref2}. Le signal de mise en conduction s2 est à un niveau haut et le transistor Tₐ est alors passant. Une fois que le condensateur 7 est entièrement déchargé, le signal s2 change de niveau et le transistor Tₐ se bloque.

La figure 3 illustre l'évolution de la tension V_{c} aux bornes du condensateur 7 en fonction du temps. Le temps de charge d1 et le temps de décharge d2 du condensateur sont égaux afin que chaque transistor Tₐ et T_{b} soient passants pendant une demi-période. Cette égalité est obtenue en utilisant deux sources de tension 6 et 8 identiques.

De préférence, le circuit de commande Comₐ se présente sous la forme d'un circuit intégré à trois broches correspondant aux trois bornes externes.

## Revendications

1. Dispositif de commande d'une lampe fluorescente à basse pression comprenant un premier et un second circuit de commutation (Comₐ,Com_{b}) placés en série entre une haute tension et la masse, le premier circuit de commutation (Comₐ) comportant un premier transistor de puissance (Tₐ), le second circuit de commutation (Com_{b}) comportant un second transistor de puissance (T_{b}), une inductance (L) étant montée en série avec la lampe fluorescente (F) à basse pression et avec un condensateur (Cs) entre le point milieu (P) des deux circuits de commutation et la masse,
caractérisé en ce que le premier circuit de commutation (Comₐ) comporte:
- un circuit de mesure (3) de la durée de conduction du second transistor de puissance (T_{b}), pour mesurer une première durée (d1), et
- un circuit de mise en conduction (4) pour rendre passant le premier transistor de puissance (Tₐ) pendant une seconde durée (d2) consécutive et égale à la première durée (d1).

2. Dispositif selon la revendication 1, caractérisé en ce que le premier circuit de commutation (Comₐ) comporte en outre un circuit de détection de la conduction du second transistor de puissance (T_{b}) comprenant un diviseur résistif (R1,R2) connecté entre la haute tension et le point milieu (P) des deux circuits de commutation, et un premier comparateur de tension (5) connecté sur une première entrée en un point (P1) du diviseur résistif et recevant sur une deuxième entrée une première valeur de référence de tension (V_{ref1}), pour délivrer un signal de détection (s1) de la conduction du second transistor de puissance (T_{b}).

3. Dispositif selon la revendication 1 ou 2, caractérisé en ce que le circuit de mesure (3) comprend une première source de courant (6) placée en série avec un condensateur (7) entre une tension d'alimentation (Vₐₗᵢₘ) et le point milieu (P) des deux circuits de commutation, la première source de courant (6) étant commandée par le signal de détection (s1), pour charger le condensateur (7) pendant que le second transistor de puissance (T_{b}) est passant.

4. Dispositif selon l'une des revendications 1 à 3, caractérisé en ce que le circuit de mise en conduction (4) comporte une seconde source de courant (8) connectée entre le point milieu (P2) de la première source de courant (6) et du condensateur (7) et le point milieu des deux circuits de commutation, la seconde source de courant étant commandée par le signal de détection inversé (/s1), un second comparateur de tension (9) connecté sur une première entrée au point milieu (P2) de la première source de courant (6) et du condensateur (7) et recevant sur une deuxième entrée une seconde valeur de référence de tension (V_{ref2}), la sortie du second comparateur de tension (9) étant connectée à la grille du premier transistor de puissance (Tₐ), pour délivrer un signal de mise en conduction (s2) du premier transistor de puissance (Tₐ).

5. Dispositif selon la revendication 4, caractérisé en ce que la seconde source de courant (8) est identique à la première source de courant (6).

6. Dispositif selon l'une des revendications 1 à 5 caractérisé en ce qu'un condensateur de découplage (Cₐ) est connecté entre la borne d'alimentation (B3ₐ) et le point milieu (P) des deux circuits de commutation pour maintenir un niveau de tension d'alimentation constant (Vₐₗᵢₘ) sur une borne d'alimentation (B3ₐ).

7. Dispositif selon la revendication 6, caractérisé en ce que le premier circuit de commutation (Comₐ) comprend un circuit de charge (10) pour charger le condensateur de découplage (Cₐ) lorsque le premier transistor de puissance (Ta) est bloqué.

## Patentansprüche

1. Steuervorrichtung für eine Niederdruckleuchtstofflampe mit einem ersten und einem zweiten Schaltkreis zum Umschalten (comₐ, Com_{b}) in Reihe zwischen einer hohen Spannung und Masse, wobei der erste Schaltkreis zum Umschalten (Comₐ) einen ersten Leistungstransistor (Tₐ) umfaßt, der zweite Schaltkreis zum Umschalten (Com_{b}) einen zweiten Leistungstransistor (T_{b}) umfaßt, eine Induktivität (L) in Reihe mit der Niederdruckleuchtstofflampe (F) und einem Kondensator (Cs) zwischen dem Mittelpunkt (P) von zwei Schaltkreisen zum Umschalten und der Masse geschaltet ist,
dadurch gekennzeichnet, daß
der erste Schaltkreis zum Umschalten (Comₐ) umfaßt:
- einen Schaltkreis (3) zum Messen der Dauer der Leitfähigkeit des zweiten Leistungstransistors (T_{b}), um eine erste Dauer (d1) zu messen, und
- einen Schaltkreis (4) zum Leitendmachen, um den ersten Leistungstransistor (Tₐ) während einer zweiten Dauer (d2) nach und gleich der ersten Dauer (d1) leitend zu machen.

2. Vorrichtung nach Anspruch 1, dadurch gekennzeichnet, daß der erste Schaltkreis zum Umschalten (Comₐ) außerdem einen Schaltkreis zum Erfassen der Leitfähigkeit des zweiten Leistungstransistors (T_{b}) mit einem Widerstandsteiler (R1, R2) zwischen der hohen Spannung und dem Mittelpunkt (P) von zwei Schaltkreisen zum Umschalten und einen ersten Spannungsvergleicher (5), der über einen ersten Eingang mit einem Punkt (P1) des Widerstandsteilers verbunden ist und über einen zweiten Eingang einen ersten Spannungsreferenzwert (v_{ref1}) empfängt, umfaßt, um ein Erfassungssignal (s1) der Leitfähigkeit des zweiten Leistungstransistors (T_{b}) auszugeben.

3. Vorrichtung nach Anspruch 1 oder 2, dadurch gekennzeichnet, daß der Schaltkreis (3) zum Messen eine erste Stromquelle (6) in Reihe mit einem Kondensator (7) zwischen eine Versorgungsspannung (Vₐₗᵢₘ) und dem Mittelpunkt (P) von zwei Schaltkreisen zum Umschalten umfaßt, wobei die erste Stromquelle (6) gesteuert wird durch das Erfassungssignal (s1), um den Kondensator (7) aufzuladen, während der zweite Leistungstransistor (T_{b}) leitend ist.

4. Vorrichtung nach einem der Ansprüche 1 bis 3, dadurch gekennzeichnet, daß der Schaltkreis zum Leitendmachen (4) eine zweite Stromquelle (8) zwischen dem Mittelpunkt (P2) der ersten Stromquelle (6) und des Kondensators (7) und dem Mittelpunkt von zwei Schaltkreisen zum Umschalten, wobei die zweite Stromquelle gesteuert wird durch das inverse Erfassungssignal (/s1), einen zweiten Spannungsvergleicher (9), der über einen ersten Eingang mit dem Mittelpunkt (P2) der ersten Stromquelle (6) und des Kondensators (7) verbunden ist und über einen zweiten Eingang einen zweiten Spannungsreferenzwert (V_{ref2}) empfängt, umfaßt, wobei der Ausgang des zweiten Spannungsvergleichers (9) mit dem Gate des ersten Leistungstransistors (Tₐ) verbunden ist, um ein Signal zum Leitendmachen (s2) des ersten Leistungstransistors (Tₐ) auszugeben.

5. Vorrichtung nach Anspruch 4, dadurch gekennzeichnet, daß die zweite Stromquelle (8) identisch mit der ersten Stromquelle (6) ist.

6. Vorrichtung nach einem der Ansprüche 1 bis 5, dadurch gekennzeichnet, daß ein Koppelkondensator (Cₐ) zwischen den Versorgungsanschluß (B3ₐ) und den Mittelpunkt (P) von zwei Schaltkreisen zum Umschalten geschaltet ist, um einen konstanten Versorgungsspannungspegel (Vₐₗᵢₘ) an einem Versorgungsanschluß (B3ₐ) aufrechtzuerhalten.

7. Vorrichtung nach Anspruch 6, dadurch gekennzeichnet, daß der erste Schaltkreis zum Umschalten (Comₐ) einen Schaltkreis (10) zum Laden für das Aufladen des Koppelkondensators (Cₐ) aufweist, wenn der erste Leistungstransistor (Ta) sperrt.

## Claims

1. Device for controlling a low-pressure fluorescent lamp comprising first and second switching circuits (Comₐ, Com_{b}) placed in series between a high voltage and earth, the first switching circuit (Comₐ) including a first power transistor (Tₐ), the second switching circuit (Com_{b}) including a second power transistor (T_{b}), an inductor (L) being connected in series with the low-pressure fluorescent lamp (F) and with a capacitor (Cs) between the mid-point (P) of the two switching circuits and earth,
characterised in that the first switching circuit (Comₐ) includes:
- a circuit (3) for measuring the period of conduction of the second power transistor (T_{b}), in order to measure a first period (d1), and
- an energising circuit (4) for making the first power transistor (Tₐ) conducting during a second period (d2) consecutive upon and equal to the first period (d1).

2. Device according to Claim 1, characterised in that the first switching circuit (Comₐ) also includes a circuit for detecting the conduction of the second power transistor (T_{b}) comprising a resistive divider (R1, R2) connected between the high voltage and the mid-point (P) of the two switching circuits, and a first voltage comparator (5) connected at a first input to a point (P1) on the resistive divider and receiving at a second input a first voltage reference value (v_{ref1}), for delivering a signal (s1) for the detection of the conduction of the second power transistor (T_{b}).

3. Device according to Claim 1 or 2, characterised in that the measuring circuit (3) comprises a first current source (6) placed in series with a capacitor (7) between a supply voltage (vₐₗᵢₘ) and the mid-point (P) of the two switching circuits, the first current source (6) being controlled by the detection signal (s1), in order to charge the capacitor (7) whilst the second power transistor (T_{b}) is conducting.

4. Device according to one of Claims 1 to 3, characterised in that the energising circuit (4) includes a second current source (8) connected between the mid-point (P2) of the first current source (6) and the capacitor (7) and the mid-point of the two switching circuits, the second current source being controlled by the inverted detection signal (/s1), a second voltage comparator (9) connected at a first input to the mid-point (P2) of the first current source (6) and of the capacitor (7) and receiving at a second input a second voltage reference value (V_{ref2}), the output of the second voltage comparator (9) being connected to the gate of the first power transistor (Tₐ), in order to deliver a signal (s2) for the energising of the first power transistor (Tₐ).

5. Device according to Claim 4, characterised in that the second current source (8) is identical to the first current source (6).

6. Device according to one of Claims 1 to 5, characterised in that a decoupling capacitor (Cₐ) is connected between the power supply terminal (B3ₐ) and the mid-point (P) of the two switching circuits in order to maintain a constant supply voltage level (Vₐₗᵢₘ) at a supply terminal (B3ₐ).

7. Device according to Claim 6, characterised in that the first switching circuit (Comₐ) comprises a charging circuit (10) for charging the decoupling capacitor (Cₐ) when the first power transistor (Tₐ) is non-conducting.
